Europäisches Patentamt

European Patent Office

Office européen des brevets

(11) Numéro de publication: **0 375 501**
**A1**

## DEMANDE DE BREVET EUROPEEN

(21) Numéro de dépôt: 89403409.9

(51) Int. Cl.5 **H01L 21/308, H01L 21/60**

(22) Date de dépôt: 08.12.89

(30) Priorité: 20.12.88 FR 8816806

(43) Date de publication de la demande:
27.06.90 Bulletin 90/26

(84) Etats contractants désignés:
DE GB NL

(71) Demandeur: THOMSON COMPOSANTS
MILITAIRES ET SPATIAUX
50, rue J.P. Timbaud
F-92400 Courbevoie(FR)

(72) Inventeur: Blanchard, Pierre
THOMSON-CSF SCPI Cédex 67
F-92045 Paris la Défense(FR)
Inventeur: Baussand, Patrick
THOMSON-CSF SCPI Cédex 67
F-92045 Paris la Défense(FR)

(74) Mandataire: Guérin, Michel et al
THOMSON-CSF SCPI
F-92045 PARIS LA DEFENSE CEDEX 67(FR)

(54) Procédé de réalisation d'ouvertures dans un circuit intégré.

(57) Formation d'ouvertures de contact au travers d'une couche de matériau isolant.

Selon l'invention, on procède à une attaque de gravure dans une première couche (12) en matériau isolant, au travers d'un masque, pour définir des ouvertures (19a, 19b) de préférence incomplètement gravées, on élimine le masque, on dépose une seconde couche (21) et on procède à une seconde attaque de gravure, sans masque, jusqu'à ce que des zones de contact sur les éléments (14, 15) soient dégagées.

FIG.4

## Procédé de réalisation d'ouvertures dans un circuit intégré

L'invention se rapporte à un procédé de réalisation d'ouvertures de contact dans une couche en matériau isolant, pendant l'élaboration d'un circuit intégré, en vue de dégager des zones de certains éléments enfouis dans ladite couche ou recouverte par celle-ci, destinées à être connectées à des éléments conducteurs d'un circuit de connexion.

L'invention permet notamment d'obtenir des ouvertures de contact de faibles dimensions.

Dans la fabrication d'un circuit intégré, certains éléments tels que des grilles de transistors à effet de champ ou des zones diffusées, doivent être raccordées à des conducteurs pour des liaisons internes entre différents composants ou des connexions extérieures. Ces éléments sont enfouis dans une couche de matériau isolant, typiquement de l'oxyde de silicium ou recouverts par une telle couche. Il est donc nécessaire de pratiquer des ouvertures dans cette couche de matériau isolant afin de dégager des zones correspondantes desdits éléments, en vue d'y raccorder des conducteurs, par exemple en aluminium. Ceux-ci sont formés par dépôt d'une couche conductrice qui pénètre dans lesdites ouvertures de contact. Cette couche conductrice est ensuite photogravée pour définir un circuit de conducteurs. La réalisation de ces ouvertures est délicate car on doit prendre en compte certaines contraintes:

- Les ouvertures doivent être de petites dimensions en raison de la topologie du circuit car il est nécessaire de conserver une certaine distance entre le contact métallique et les éléments de circuit actifs les plus proches (grilles, zones diffusées ...). Dans la pratique, la réduction des dimensions de ces ouvertures peut être limitée par la résolution du procédé de photolithographie utilisé pour la réalisation des masques.

- Les ouvertures doivent être pratiquées au travers d'épaisseurs variables de matériau isolant, ce qui peut poser des problèmes pour déterminer la fin des attaques de gravure. De toutes façons, la détection de fin d'attaque, qui se fait généralement par l'analyse sur raies spectrales caractéristiques de la couche à graver, est peu précise en raison de la faible surface globale des ouvertures à pratiquer et donc d'une brillance très réduite de ces raies. En effet, la détection de fin d'attaque est actuellement basée sur le suivi de l'évolution de raies spectrales caractérisant la réaction chimique de gravure entre le gaz utilisé et la couche à graver. On surveille donc l'apparition ou la disparition de certaines raies.

- En outre, le profil en profondeur de l'ouverture doit être particulier, notamment évasé vers la surface, pour faciliter la mise en place des connexions métalliques.

Cette dernière contrainte a conduit à utiliser plusieurs techniques. L'une consiste à mettre en oeuvre deux séquences successives de photolithogravure, avec des masques différents. Une autre méthode dite de "facettage" permet d'obtenir l'évasement voulu en une seule phase, par consommation latérale de la résine du masque. Ce profil particulier recherché rend encore plus délicate la réalisation de structures denses, à cause de la nécessité évoquée ci-dessus de conserver une certaine distance entre chaque partie métallique, notamment sa portion évasée, et les éléments actifs les plus proches.

L'invention permet de réaliser un meilleur compromis entre toutes ces contraintes et notamment de réaliser des ouvertures plus petites que ce que permettrait normalement la résolution photolithographique. Elle permet d'obtenir les ouvertures à partir d'une seule opération de masquage, sans attaque latérale de celui-ci, donc avec une plus grande maîtrise des formes et dimensions desdites ouvertures.

Dans cet esprit, l'invention concerne donc un procédé de réalisation d'ouvertures de contact dans une première couche, en matériau isolant, d'un circuit intégré, caractérisé en ce qu'il consiste:

- à déposer un masque sur ladite première couche, comportant des fenêtres aux emplacements souhaités desdites ouvertures,

- à soumettre ladite première couche recouverte dudit masque à une première attaque de gravure,

- à éliminer ledit masque,

- à déposer une seconde couche sur ladite première couche, ladite seconde couche pénétrant dans les ouvertures incomplètement gravées, et

- à soumettre l'ensemble ainsi obtenu à une nouvelle attaque de gravure, en l'absence de masque, en poursuivant cette attaque jusqu'à atteindre des zones de contact à raccorder, au fond desdites ouvertures de contact ainsi achevées.

Les étapes d'attaque de gravure précitées sont réalisées de préférence en mode anisotrope, c'est-à-dire en privilégiant l'attaque en profondeur, avec un très faible retrait latéral.

L'invention sera mieux comprise et d'autres avantages de celle-ci apparaîtront plus clairement à la lumière de la description qui va suivre, de plusieurs modes d'exécution d'un procédé conforme à son principe, donnée uniquement à titre d'exemple, et faite en référence aux dessins annexés dans lesquels:

- les figures 1 à 5 illustrent les principales phases d'un procédé de réalisation d'ouvertures de contact conforme à l'invention;

- les figures 6 et 7 illustrent la formation d'éléments conducteurs; et

- les figures 8 et 9 sont des vues respectivement analogues aux figures 4 et 5 et illustrent une variante.

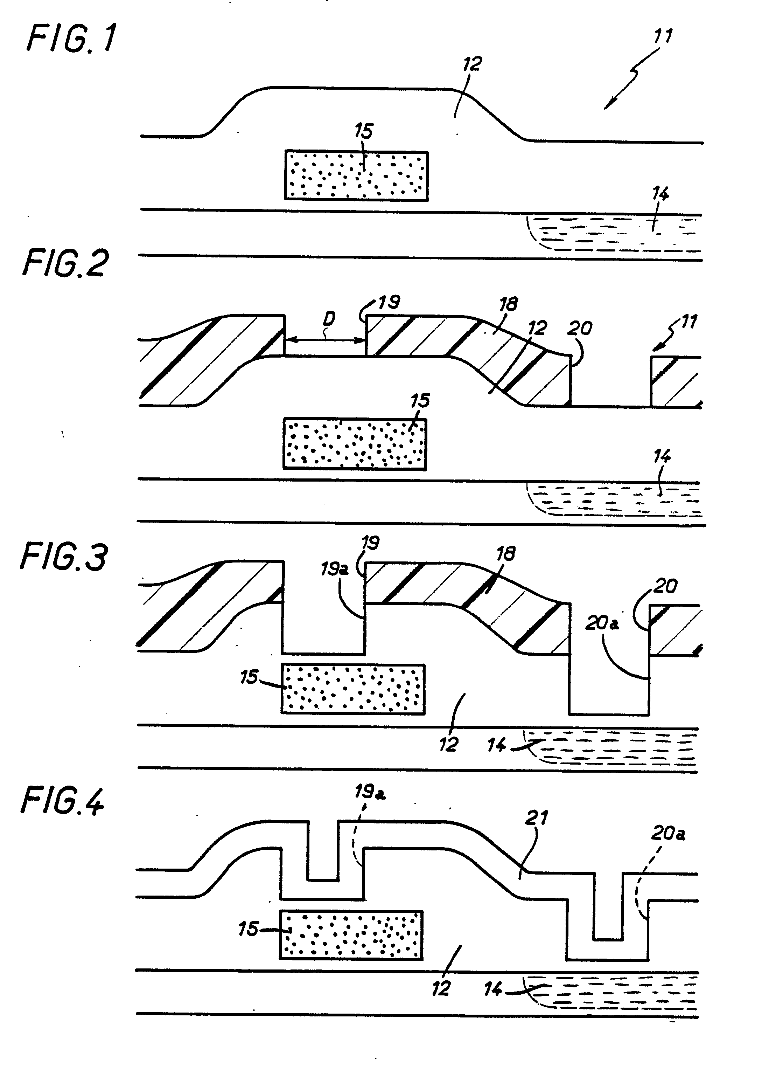

En considérant plus particulièrement les figures 1 à 5, on a illustré les étapes de formation de deux ouvertures de contact dans un circuit intégré 11 en cours de fabrication. Ces ouvertures sont pratiquées au travers d'une couche de matériau isolant 12, appelé ici première couche, qui, dans l'exemple décrit est en oxyde de silicium. Cette première couche recouvre une autre couche dans laquelle est définie une zone diffusée 14. Par ailleurs, un autre élément formant grille 15, en silicium polycristallin, est enfoui dans ladite première couche 12. C'est l'état du futur circuit intégré tel qu'il est illustré à la figure 1. Il s'agit donc de pratiquer des ouvertures dans ladite première couche 12 pour dégager des surfaces de raccordement au niveau des différents éléments tels que, selon l'exemple, la zone diffusée 14 et la grille 15. On commence donc par déposer un masque 18 sur ladite première couche (figure 2) comportant des fenêtres 19, 20 aux emplacements souhaités des ouvertures de contact à réaliser. Pour comprendre l'un des avantages du procédé conforme à l'invention, on peut supposer que la dimension D des fenêtres 19, 20 dans le masque, est aussi faible que ce que permet la résolution de la photolithographie utilisée pour réaliser le masque 18, mais qu'on désire obtenir des ouvertures encore plus petites. Il est à noter que les modes opératoires pour déposer les couches et les masques sont classiques et ne seront donc pas décrits en détails; il en est de même pour les gravures ou attaques de ces couches et pour l'élimination du masque.

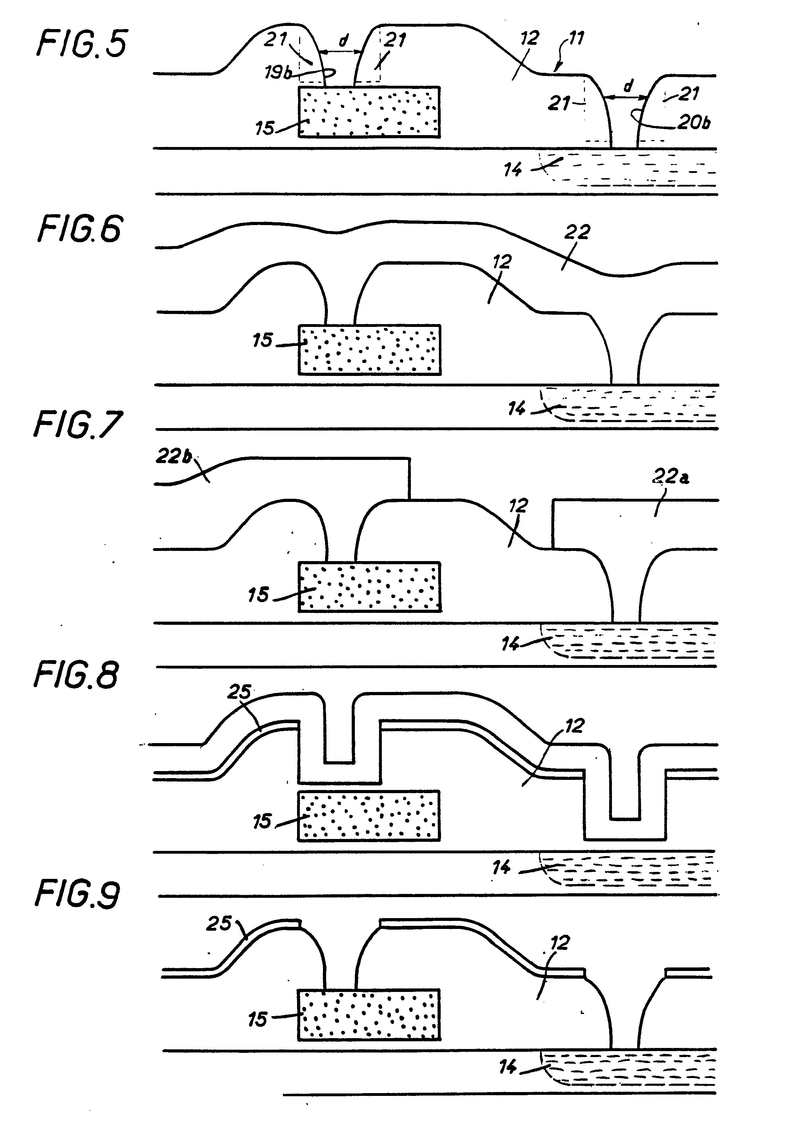

Après la formation du masque 18, on soumet la première couche 12 à une attaque de gravure du type anisotrope. Le matériau isolant est donc attaqué dans les parties de la couche 12 qui sont en regard des fenêtres 19, 20. L'attaque de gravure est interrompue avant élimination complète du matériau isolant aux emplacements desdites fenêtres 19, 20. Autrement dit, comme cela apparaît sur la figure 3, ni la zone diffusée 14, ni la grille 15 n'est atteinte à ce stade du procédé et on obtient des ouvertures 19a, 20a incomplètement gravées, ceci pour ne pas mettre à nu deux fois les éléments à connecter. Toutefois, on pourrait éventuellement "ouvrir" complètement ces ouvertures à ce stade du procédé. On élimine ensuite le masque 18 et on dépose une seconde couche 21 sur ladite couche 12 incomplètement gravée. Dans l'exemple décrit, il s'agit d'une couche de matériau isolant, par exemple dans le même matériau que celui qui constitue ladite première couche 12, c'est-à-dire de l'oxyde de silicium. Cette seconde couche pénètre dans les ouvertures 19a, 20a incomplètement gravées; c'est la situation illustrée à la figure 4. On soumet alors l'ensemble ainsi obtenu à une nouvelle attaque de gravure, en l'absence de masque et on poursuit cette fois l'attaque de gravure jusqu'à élimination complète du matériau isolant au fond des ouvertures 19a, 19b, c'est-à-dire jusqu'à atteindre et dégager des zones de contact sur la zone diffusée 14 aussi bien que sur la grille 15. Sur la figure 5, les ouvertures de contact 19b, 20b sont achevées; elles ont une section plus faible que ce qu'aurait permis une simple gravure réalisée à partir du masque 18. Cette réduction des dimensions de l'ouverture apparaît clairement en comparant la largeur d de l'ouverture 19b ou 20b (figure 5) à la largeur D des fenêtres 19, 20 du masque 18. De plus, la seconde attaque de gravure réalisée sans masque donne naturellement aux ouvertures 19b, 20b, la forme évasée souhaitable pour l'établissement de bons contacts. La réalisation des contacts est obtenue de façon classique par dépôt d'une couche d'aluminium 22 (figure 6) puis par une nouvelle photolithogravure aboutissant à définir dans la couche 22 tout un circuit de connexions individualisées 22a, 22b, ... (figure 7).

Les figures 7 et 8 correspondent respectivement aux figures 4 et 5 et illustrent une variante du procédé consistant à déposer une couche de protection 25 sur la première couche 12, avant le dépot du masque 18. On conserve ainsi l'intégralité de ladite première couche (figure 9) lors de la seconde attaque de gravure. Cette couche de protection peut être en silicium pur ou en nitrure de silicium. La couche 25 peut aussi servir à ajuster la fin d'attaque de gravure. En effet, lorsque la couche de protection vient à être découverte, on peut détecter un changement appréciable dans la composition du dégagement gazeux. Il suffit alors de prolonger l'attaque de gravure d'une durée prédéterminée pour achever la formation des ouvertures de contact. On s'affranchit ainsi de l'imprécision dans la détermination de la fin d'attaque, liée aux tolérances sur l'épaisseur de la seconde couche. Cette dernière peut en outre (avec ou sans couche de protection) être d'un matériau différent de celui de la première couche, éventuellement un matériau conducteur. Les parties subsistantes de la seconde couche (figure 5) dans les ouvertures de contact pourront alors se combiner avec les contacts rapportés ultérieurement, comme indiqué ci-dessus.

## Revendications

1. Procédé de réalisation d'ouvertures de contact dans une première couche (12) en matériau isolant d'un circuit intégré, caractérisé en ce qu'il consiste :

- à déposer un masque (18)sur ladite première couche, comportant des fenêtres (19, 20) aux emplacements souhaités desdites ouvertures,
- à soumettre ladite première couche recouverte dudit masque à une première attaque de gravure,
- à interrompre la première attaque de gravure avant élimination complète du matériau isolant aux emplacements desdites fenêtres (19, 20),
- à éliminer ledit masque (18),
- à déposer une seconde couche (21) sur ladite première couche, ladite seconde couche pénétrant dans les ouvertures incomplètement gravées, et
- à soumettre l'ensemble ainsi obtenu à une nouvelle attaque de gravure, en l'absence de masque, en poursuivant cette attaque jusqu'à atteindre des zones de contact à raccorder au fond desdites ouvertures de contact (19b, 20b) ainsi achevées.

2. Procédé selon la revendication 1, caractérisé en ce que ladite seconde couche (21) est en matériau isolant, par exemple le même matériau que celui la dite première couche.

3. Procédé selon la revendication 2, caractérisé en ce que lesdites première et seconde couches sont en oxyde de silicium.

4. Procédé selon l'une des revendications précédentes, caractérisé en ce qu'il consiste à déposer une couche de protection (25) sur ladite première couche (12) avant le dépôt dudit masque (18).

FIG.1

FIG.2

FIG.3

FIG.4

FIG.5

FIG.6

FIG.7

FIG.8

FIG.9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 176 010  (TEXAS INSTRUMENTS) * Revendication 1; page 15, lignes 3-22; figures 2A-C * | 1 | H 01 L   21/308 H 01 L   21/60 |
| A | --- | 2-4 | |
| Y | IBM TECHNICAL DISCLOSURE BULLETIN, vol. 22, no. 4, septembre 1979, pages 1464-1465; B.M. KEMLAGE: Multiple Depth Dielectric Isolation From a Single Mask" * En entier * | 1 | |
| A | IDEM ----- | 3 | |

DOMAINES TECHNIQUES
RECHERCHES (Int. Cl.5)

H 01 L

Le présent rapport a été établi pour toutes les revendications

| Lieu de la recherche | Date d'achèvement de la recherche | Examinateur |
|---|---|---|
| LA HAYE | 07-03-1990 | PHEASANT N.J. |

EPO FORM 1503 03.82 (P0402)